# EUROPEAN PATENT APPLICATION

(11) **EP 2 226 838 A1**
(43) Date of publication of application: **08.09.2010**
(21) Application number: 09154319.9
(22) Date of filing: 04.03.2009
(51) Int. Cl.: H01L 21/60, H01L 21/00, B22F 7/06

(54) **Fixture apparatus for low-temperature and low-pressure sintering**

(71) Applicant: ABB Research Ltd., 8050 Zürich (CH)
(72) Inventor: Liu, Chunlei, CH-8051 Zürich (CH); Hartmann, Samuel, CH-5512 Wohlenschwil (CH)
(74) Representative: ABB Patent Attorneys

(57) **Abstract**

The invention relates to a fixture apparatus (1; 20) for bonding a plurality of elements (7, 9; 21, 22) by sintering a bonding layer (8; 23) sandwiched between the elements (7, 9; 21, 22); comprising a support frame (2; 24); a clamping means (3; 25); a reception region for receiving a stack (4) including the plurality of elements (7, 9; 21, 22) in-between which the bonding layer (8; 23) is arranged, wherein the clamping means (3; 25) is adapted to clamp the stack (4) when loaded into the reception region and to permanently apply a sintering pressure. The fixture apparatus (1; 20) can be applied in a method for bonding a plurality of elements (7, 9; 21, 22) using a sintering process. The method comprises the steps of clamping the stack (4) into the reception region of the fixture apparatus (1; 20), and applying heat to the stack (4) and the bonding layer (8; 23) to perform a sintering process of the bonding layer (8; 23).

## Description

### Field of the invention

The present invention relates to sintering as a method for bonding of elements, such as electronic devices, silicon dice, metal plates, diverse metal an protection layers and the like, e.g. for bonding a chip onto a substrate, in particular to silver sintering. The present invention further relates to the process of producing a bond between electronic devices or between one or more electronic devices and a substrate.

### Related art

Silver sintering is a suitable method for low-temperature bonding, e.g. for bonding an element such as an electronic device, a silicon die or the like, onto another element, such as a silicon die, a substrate or another electronic device. The process of silver sintering allows to electrically and mechanically interconnect the elements (e.g. the die and the substrate) at a low temperature and low pressure such that the resulting interconnection provides a sufficient electrical conductivity and a low heat resistivity. In comparison to soldered die bonds, the sintered joints show a higher reliability and a higher operating temperature capability. For instance, it has been shown that power modules with sintered chip-attachment have a three times better performance, a five times better reliability, and a higher chip junction temperature up to 175°C.

In the bonding process, a layer of a paste including nanoscale or microscale silver powder may be applied between the elements to be bonded. Thereafter, pressure and heat are supplied simultaneously for a duration of several minutes. The bonding process is usually performed using a press that has a heating integrated in its press stamp to simultaneously apply a pressure of e.g. about 8 MPa and heat of about 300°C. Since the conditions must be maintained for several minutes, the throughput of a bonding apparatus having such a press is limited.

It is therefore an object to provide an apparatus and a method which allow a bonding process using sintering to become more efficient, particularly, to increase the overall throughput for bonding a plurality of elements in a production line.

### Summary of the invention

This object is achieved by the fixture apparatus according to claim 1, the method for bonding a plurality of elements, and the use of the fixture apparatus according to the further independent claims.

Further embodiments are indicated in the dependent claims.

According to a first aspect, a fixture apparatus for bonding a plurality of elements by sintering a bonding layer sandwiched between the elements is provided. The fixture apparatus comprises a support frame, a clamping means, and a reception region for receiving a stack including a plurality of elements in-between which the bonding layer is arranged. The clamping means is adapted to clamp the stack when loaded into the reception region and to permanently apply a sintering pressure.

One idea of the present invention is to separate the process of applying pressure from the process of applying heat. This is performed by means of the above fixture apparatus, which allows to permanently apply the sintering pressure onto the elements to be bonded during the sintering process without the need of an appropriate press. Thus, the fixture apparatus loaded with the elements allows to maintain the sintering pressure while the stack comprising the elements and the bonding layer loaded into the fixture apparatus are exposed to heat in order to perform the sintering process. Typically the bonding layer is a metal paste such as silver paste with micro or nano silver particles, which can also comprise silver compounds.

The fixture apparatus may be constructed to permanently apply pressure on the plurality of elements, i.e. a plurality of stacked dice or a die on a substrate, by means of a force-applying element. The fixture apparatus loaded with the one or more stacked elements can then be exposed to heat such that the sintering process is performed.

Prior art press units apply heat and pressure simultaneously on stacked elements and have to maintain pressure for a significant period of time as outlined above. In contrast thereto, the fixture apparatus loaded with the stack including the devices and/or substrates enables to perform a bonding by maintaining the sintering pressure while the sintering temperature is applied separately.

Furthermore, the clamping means may be adapted to receive the stack biased with the sintering pressure and to clamp the stack while maintaining the sintering pressure. In particular, the sintering pressure may be in the range from 1 to 20 MPa. In one embodiment the clamping means may include a spring.

In alternative embodiments, the support frame may have a support portion and a pressure maintaining portion wherein the sintering pressure is applied on the stack received in the reception region by assembling the support portion and the pressure maintaining portion thereby biasing a force-applying element of the clamping means to provide the sintering pressure. Particularly, the support portion and the pressure maintaining portion are fastened at each other by means of one or more screws or by means of a fastening bolt.

Moreover, the clamping means may have a stamp which includes a material having a thermal expansion coefficient which is higher than the thermal expansion coefficient of at least a portion of the support frame, such when at least the clamping means is heated, pressure is exposed to the stack loaded into the reception region due to a thermal expansion difference.

According to a further embodiment, the clamping means may have a cavity to receive a heater element for heating the clamping means, wherein the clamping means is further adapted to transfer the heat from the heater element to the stack via a stamp head which is formed by the end of the stamp applying pressure onto the stack.

The stamp may be comprised in a stamp arrangement wherein the stamp is put on the elements to be bonded and wherein a biasing screw is associated to the stamp which can be tightened into a corresponding opening in the support frame to pressure bias the stamp onto the stack.

According to another embodiment, a plurality of clamping means are provided to perform the bonding of a plurality of elements in the fixture apparatus. In particular, the support frame may be adapted to hold a common substrate onto which the plurality of devices are to be bonded, wherein each of the plurality of devices are clamped by means of the corresponding clamping means.

According to a further aspect, a method for bonding a plurality of elements using a sintering process to produce a stack of elements is provided. The method comprises the steps of:
- clamping the stack into the reception region of the above mentioned fixture apparatus;
- applying heat to the elements and the bonding layer to perform a sintering process of the bonding layer after the stack has been clamped in the reception region.

Moreover, prior to or during the clamping of the stack into the reception region, a sintering pressure is applied to the stack wherein, while the stack being clamped, the pressure on the stack is maintained.

The clamping of the stack may be further performed to fixate the stack in the reception region wherein pressure is applied to the stack by applying heat to at least the clamping means such that pressure is generated due to the thermal expansion of the clamping means.

According to a further aspect, a use of the above fixture apparatus for sintering the bonding layer to bond the plurality of elements in the stack is provided, wherein the fixture apparatus is loaded with the stack and at least the clamping means of the fixture apparatus is heated at a sintering temperature.

### Brief description of the drawings

In the following descriptions, embodiments are described in detail in conjunction with the accompanying drawings, in which:
- Figure 1: shows a cross-sectional view of a fixture apparatus loaded with a die stacked on a substrate;
- Figures 2a and 2b: show a cross-sectional view of a fixture apparatus loaded with three stacks of elements in an unassembled and assembled state;
- Figures 3a and 3b: show a cross-sectional view of a fixture apparatus loaded with three stacks of elements in an unassembled and assembled state;
- Figure 4: shows a cross-sectional view of another fixture apparatus for bonding a plurality of dies on a substrate simultaneously;
- Figure 5: shows a cross-sectional view of another fixture apparatus for bonding a plurality of dies on a substrate simultaneously.

### Detailed description of the embodiments

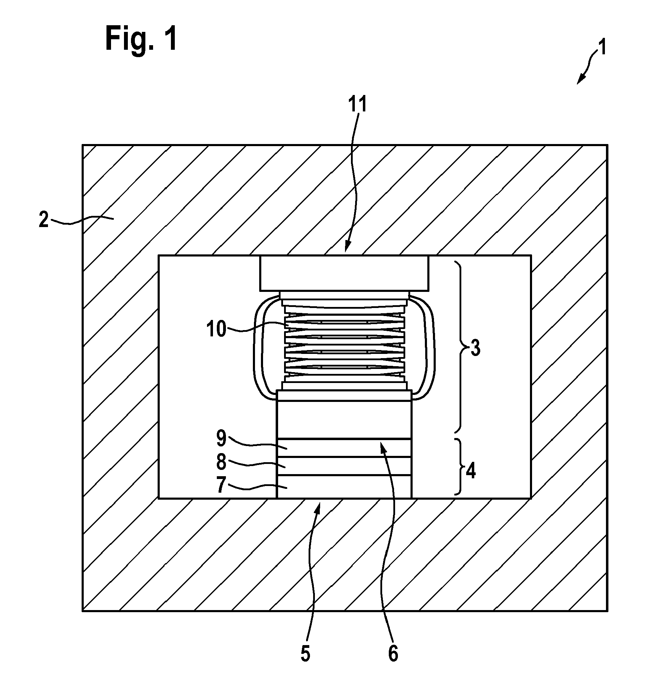

In Figure 1, a cross-sectional view of a general fixture apparatus 1 is shown.

In general, the fixture apparatus is adapted to apply a permanent pressure onto a stack including a plurality of elements stacked on each other. Each of the elements contained in the stack can be an electrical device, an electronic device, an electromechanical device, a plate made of conductive or non-conductive material, such as a metal plate or a insulating plate, a semiconductor die, a metal layer, a protective layer or a substrate. In the stack the elements are stapled or stacked, respectively, such that corresponding bonding regions at which neighboring elements shall be bonded, are facing each other. Preferably, the elements are stackable, i.e. the elements provide bonding regions which extend substantially orthogonal to the stacking direction such that no substantial lateral force is caused between the stacked elements. For instance, the stack can include a substrate, such as a silicon wafer, a printed circuit board or the like, and one or more dice, i.e. one or more silicon chips or the like, as elements. In-between the bonding regions of the elements to be bonded a silver paste may be applied serving as a bonding material.

In detail, the fixture apparatus 1 of Figure 1 has a frame 2, in which a pressure stamp 3 is provided. The frame 2 supports a stamp 3 which allows to clamp a stack 4 between a first pressure plane 5 of the frame 2 and a second pressure plane 6 located at the stamp 3. Between the first and the second pressure planes 5, 6, the stack 4 is arranged. In the present embodiment, the stack 4 includes a substrate 7 as a first element and a chip 9 as a second element, in between which the silver paste layer 8 as a bonding material is applied. In the given example the stamp 3 puts pressure on the chip 8 while the substrate 7 abuts the frame 2.

Of course, it may also be provided that the stamp 3 presses on the substrate 7 while the chip 9 abuts the frame 2. Moreover, in an alternative embodiment two stamps may be arranged within the frame 2 which provide the respective pressure planes for putting the pressure on the stack.

The silver paste layer 8 may be made of a silver paste which is applied on the substrate 7 (first element of the stack) such that it forms a layer of equal thickness e,g. using a squeegee before the chip 9 is put on the silver paste layer 8 with its bonding region. The silver paste may comprise nanoscale silver powder having particles smaller than 500 nm, preferably 10 to 100 nm silver particles, preferably 30 nm to 50 nm silver particles. The paste may further include a solvent, which allows the easy application of the silver paste onto the substrate 7 in a high reproducibility. The silver paste is applied as a layer with a thickness of 30 µm to 200 µm, preferably between 50 µm and 100 µm. Alternatively, the bonding material may comprise a paste which may contain a mixture of silver compounds and/or micro-size silver particles.

In one embodiment, the so formed stack 3 is exposed to pressure and inserted into the fixture device, such that the stamp 3 presses on the stack 4 to exert a permanent pressure thereon. The pressure to be applied on the stack 4 is between 1 MPa to 20 MPa, preferably between 5 MPa and 12 MPa, more preferably between 7 MPa and 9 MPa, such as approximately 8 MPa.

The stamp 3 is provided with a force-applying element 10, e.g. a spring, which is biasing the stamp 3 to apply a pressure between a stop plane 11 of the frame 2 and one side of the stack 4. The force-applying element 10 may be formed by a resilient element (e.g. a spring) and is generally adapted to provide a force between the stop plane 11 of the frame 2 and the second pressure plane 6 in an extending direction of the stamp 3, i.e. that opposing ends of the stamp 3 are pressed apart from each other in the direction in which pressure shall be applied onto the stack 4.

After loading the fixture device 1 with the stack 4 to be bonded, the assembly is put into a heat chamber (not shown). In the heat chamber the assembly is heated to a temperature which allows a sintering process of the silver particles in the silver paste 8 to get started. If silver paste is used as a bonding layer, typically temperatures of 200 to 350 °C, preferably 230 to 300 °C are applied. The sintering process requires an application of heat to the silver paste for a duration of several minutes to several hours, while the thickness of the silver paste layer 9 slightly shrinks. The force-applying element 10 pushes the stamp 3 onto the stack 4 and allows a compensation of the change in the overall thickness of the stack 4 due to the shrinkage of the thickness of the silver paste layer 9.

In a manufacturing environment, a plurality of these fixture apparatuses, each loaded with one or more stacks 4, each of the stacks 4 biased with pressure by the force-applying element 10, are exposed to heat e.g. by introducing them into a heat chamber or the like, to perform simultaneous bonding processes by sintering the respective silver paste layers of the stacks 4.

By using a fixture apparatus 1, the process of bonding the stack 4 can be highly parallelized, such a batch processing can be performed. Thereby, the throughput is greatly increased compared to a single bonding apparatus, as described initially.

Optionally, the fixture apparatus 1 that applies the pressure to the stack 4 while sintering can be used to provide a contacting with the stack 4 even after the bonding process is completed.

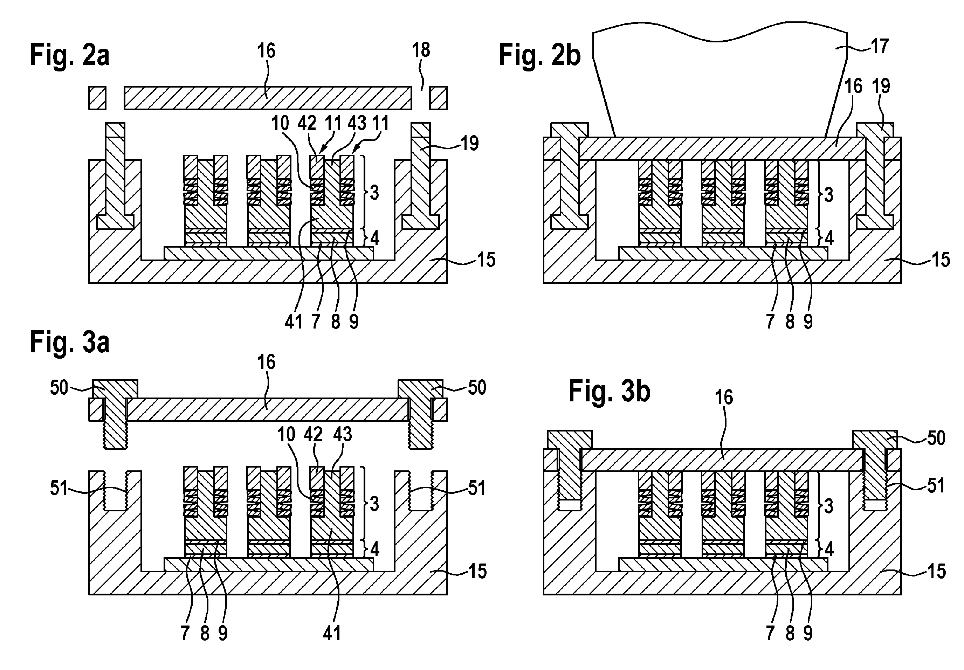

In alternative embodiments, as shown in figures 2a, 2b and 3a, 3b, the support frame is made of a support portion 15 and a pressure maintaining portion 16. In the support portion 15 three (as an example) stamps 3 are arranged which are associated to corresponding stacks 4 in the above described manner. Each of the stamps 3 comprises the force-applying element 10. In Fig. 2a the support portion 15 and the pressure maintaining portion 16 are shown in an unassembled state wherein the force-applying element 10 is relaxed, while in Fig. 2b the pressure maintaining portion 16 is attached at the support portion 15.

As a difference to the embodiment shown in Figure 1 the pressure is applied onto the stack 4 while attaching the pressure maintaining portion 16 onto the support portion 15. In embodiment of Fig.s 2a and 2b the pressure maintaining portion 16 is pressed onto the support portion 15 using a press stamp 17. This results in a biasing the force-applying element 10 in the stamps 3.

In detail, each stamp 3 includes a stamp portion 41 providing the second pressure plane 6 and a movable member 42 which has the first pressure plane 11 and which is guided at the stamp portion 41 by means of a guidance element 43 which protrudes from the stamp portion 41 in direction to the pressure maintaining portion 16 to be attached. In other words the movable member 42 is guided in a direction of the force applied onto the stack 4. Between the movable member 42 and the stamp portion 41 the force-applying element 10, e.g. as a spring coil, is inserted. While assembling, the pressure maintaining portion 16 is pressed onto the support portion 15 by means of the press stamp 17 such that the movable member 42 of each stamp 3 is moved towards the stack 4 in a guided manner to load the force-applying element 10 such that a permanent pressure is applied onto the stack 4 when the frame is in an assembled state.

To maintain the pressure on the stack 4 the pressure maintaining portion 16 has openings 18. The openings 18 are adapted to receive a fastening bolt 19 rigidly attached to the support portion 15 such that the pressure maintaining portion 16 is locked in pressed condition onto the support portion 15 thereby maintaining the pressure on the stack 4. The locking of the pressure maintaining portion 16 can be performed by turning a locking element at an end of the fastening bolt 19 to provide a stop for the pressure maintaining portion 16 to be pushed back by the biased force-applying element 10.

In a further embodiment as shown in Figures 3a and 3b the force is generated adn applied by means of fastening screws 50 which are passing through the opening 18 of the pressure maintaining portion 16 and which can be screwed into respective internal threads 51 (having a winding) included in the support portion 15. By tightening the screws 50 the force is applied onto the stamps 3 such that the force-applying element 10 (e.g. a coil spring) is biased.

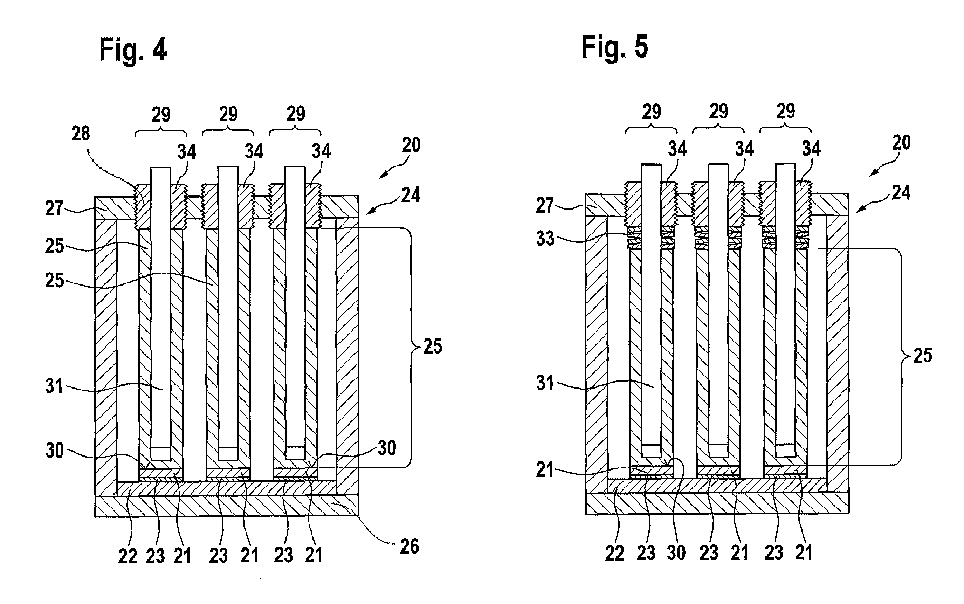

Figure 4 shows a different embodiment of the present invention. In Figure 4, a fixture apparatus 20 is shown for supporting a bonding process of a plurality of chips 21 onto a common substrate 22. After applying a respective silver paste layer 23 between the chips 21 and the common substrate 22, the so formed stack is loaded into the fixture apparatus 20.

The fixture apparatus 20 includes a frame 24 having stamps 25, each associated to one of the chips 21 of the stack. The fixture device 20 comprises a bottom plate 26 which provides a supporting plane to hold the stack formed by the substrate 22 and the chips 21. The bottom plate 26 may be provided with a heat source such that heat can be applied to the stack via the first supporting plane.

The fixture apparatus 20 further comprises a top plate 27 having openings 28 through which stamp arrangements 29 are inserted into the frame 24 such that they are projecting towards a corresponding chip 21 of the stack. Each of the stamp arrangements 29 include one of the stamps 25, which comprises a pressure region 30 which is associated to a corresponding one of the chips 21 of the stack. The stamp 25 preferably has a cylindrical shape with a circular cross-section, with a cross-section of another shape or with a cross-section of a shape which corresponds to the surface of the chip 21 to be bonded or which is greater than the surface of the chip 21. At least the pressure region 30 of each stamp 25 should have a shape which allows to equally expose pressure onto the corresponding one of the chips 21.

Instead of using a heat chamber to apply the heat to the silver paste layer 23 by exposing the whole fixture apparatus to a heat environment, the stamp 25 may comprise heating means which allow to directly produce heat in or at the stamp 25. For instance, and as shown in the given example, the stamp 25 may be provided with a cavity which has its opening on a side of the stamp 25 opposite to the pressure plane 30. Then a heat source, e.g. an electrically heated rod or the like, can be inserted into the respective cavity 32 of each of the stamps 25.

The stack may be pressure biased by means of biasing screws 34, which allow biasing the stamp 25 such that an initial pressure is applied onto the respective chip 21 of the stack before the whole assembly having the fixture apparatus 20 loaded with the stack is performing a sintering operation by applying heat to the chips 21 on the stack.

To produce the necessary pressure while exposing the stack to a sintering temperature, the stamp 25 may be made of a material having a high thermal expansion coefficient while the frame 24 of the fixture apparatus 20 has a lower thermal expansion coefficient, such that, when heat is applied to the stamp, the thermal expansion of the stamp 25 is larger than that of the frame 24 of the fixture apparatus 20. Thereby, the stack can be loaded into the fixture apparatus 20 without the need of an additional pressing process for prepressurizing the stack before loading it into the fixture apparatus 20. In other words, a pressure biasing of the stack at a room temperature is not necessary.

The stack may be loaded into the fixture apparatus 20 by inserting the stack onto the bottom plate 26, arranging the stamp 25 onto the chips 21 and tying up the biasing screw 34 such that the stamp 25 engages with the respective chip 21 via pressure plane 30. While heating the stamp 25, the higher thermal expansion of the stamp 25 results in an increasing pressure on the stack, such that both the bonding temperature for sintering the silver paste layer 23 and the pressure required by the bonding process are simultaneously applied.

Another embodiment, which is shown in Fig. 5 is similar to the embodiment of Fig. 4. In difference, further biasing means 33 are provided between the biasing screws 34 and the stamp 25. The biasing means 33 are formed as springs in order to provide a permanent pressure when loaded. Thereby, a bias pressure can be applied to the chips 21 of the stack already at room temperature. One benefit of such a fixture apparatus 20 is that the sintering pressure applied to the chips 21 while heated can be maintained more constant, even when the thickness of the bonding layer 23 shrinks during the sintering process.

The stamp 25 may contain aluminum or zinc as example materials. As a material for the frame 24 of the fixture apparatus 20, invar can be used, for instance.

### Reference list

- 1: Fixture apparatus
- 2: Frame
- 3: Stamp
- 4: Stack
- 5: First pressure plane
- 6: Second pressure plane
- 7: Substrate
- 8: Bonding layer
- 9: Chip
- 10: Force-applying element
- 11: Stop plane
- 15: Support portion
- 16: Pressure maintaining portion
- 17: Pressure stamp
- 18: Opening
- 19: Fastening bolt
- 20: Fixture apparatus
- 21: Chip
- 22: Substrate
- 23: Bonding layer
- 24: Frame
- 25: Stamp
- 26: Bottom plate
- 27: Top plate
- 28: Openings
- 29: Stamp arrangement
- 30: Pressure plane
- 31: Cavity
- 33: Biasing means
- 34: Biasing screw
- 41: Stamp portion
- 42: Movable member
- 43: Guidance element
- 50: Fastening screw
- 51: Internal thread

## Claims

1. Fixture apparatus (1; 20) for bonding a plurality of elements (7, 9; 21, 22) by sintering a bonding layer (8; 23) between the elements (7, 9; 21, 22); comprising:
- a support frame (2; 24);
- a clamping means (3; 25);
- a reception region for receiving a stack (4) including the plurality of elements (7, 9; 21, 22) in-between which the bonding layer (8; 23) is arranged;
wherein the clamping means (3; 25) is adapted to clamp the stack (4) when loaded into the reception region and to permanently apply a sintering pressure.

2. Fixture apparatus (1; 20) according to claim 1, wherein the clamping means (3; 25) is adapted to receive the stack (4) biased with the sintering pressure and to clamp the stack (4) while maintaining the sintering pressure.

3. Fixture apparatus (1; 20) according to claim 1, wherein the support frame (2) has a support portion (15) and a pressure maintaining portion (16) wherein the sintering pressure is applied on the stack (4) received in the reception region by assembling the support portion (15) and the pressure maintaining portion (16) thereby biasing a force-applying element (10) of the clamping means (3) to provide the sintering pressure.

4. Fixture apparatus (1; 20) according to claim 3, wherein the support portion (15) and the pressure maintaining portion (16) are fastened at each other by fastening means, i.e. particularly by means of one or more screws (50) or by means of a fastening bolt (19).

5. Fixture apparatus (1; 20) according to one of the claims 1 to 4, wherein the sintering pressure is between1 MPa to 20 MPa.

6. Fixture apparatus (1; 20) according to one of the claims 1 to 5, wherein the clamping means includes a resilient element, in particular a spring.

7. Fixture apparatus (1; 20) according to one of the claims 1 to 6, wherein the clamping means (3; 25) has a stamp (3; 25) which includes a material having a thermal expansion coefficient which is higher than a thermal expansion coefficient of at least a portion of the support frame (2; 24), such when the clamping means is heated, pressure is exposed to the stack (4) loaded into the reception region due to a thermal expansion difference.

8. Fixture apparatus (1; 20) according to one of the claims 1 to 7, wherein the clamping means (25) has a cavity to receive a heater element for heating the clamping means (25), wherein the clamping means (25) is further adapted to transfer the heat from the heater element to the stack via a stamp head which is formed by the end of the stamp applying pressure onto the stack.

9. Fixture apparatus (1; 20) according to one of the claims 1 to 8, wherein the stamp (25) is comprised in a stamp arrangement (29) wherein the stamp (25) is put on the elements (21, 22) to be bonded and wherein a biasing screw (34) is associated to the stamp (25) which can be tied into a corresponding opening in the support frame (2; 24) to pressure bias the stamp onto the stack (4).

10. Fixture apparatus (1; 20) according to one of the claims 1 to 9, wherein a plurality of clamping means (3; 25) are provided to perform the bonding of a plurality of elements (7, 9; 21, 22) in the fixture apparatus (1; 20).

11. Fixture apparatus (1; 20) according to claim 10, wherein the support frame (2; 24) is adapted to hold a common substrate (7; 27) onto which the plurality of elements (7, 9; 21, 22) are to be bonded, wherein each of the plurality of elements (7, 9; 21, 22) are clamped by means of the respective clamping means (3; 25).

12. Method for bonding a plurality of elements (7, 9; 21, 22) by a sintering process to produce a stack (4) of elements (7, 9; 21, 22), comprising the steps of:
- clamping the stack (4) into the reception region of the fixture apparatus (1; 20) according to one of the claims 1 to 8;
- applying heat to the elements (7, 9; 21, 22) and the bonding layer (8; 23) to perform a sintering process of the bonding layer (8; 23) after the stack (4) has been clamped to the reception region.

13. Method according to claim 12, wherein prior to or during the clamping of the stack (4) into the reception region a sintering pressure is applied to the stack (4) wherein, while the stack (4) being clamped, the pressure on the stack is maintained.

14. Method according to claim 12, wherein the clamping of the stack (4) is performed to fixate the stack (4) in the reception region wherein pressure is applied to the stack (4) by applying heat to at least the clamping means (3; 25) such that pressure is generated due to the thermal expansion of the clamping means (3; 25).

15. Use of a fixture apparatus (1; 20) according to one of the claims 1 to 11 for sintering the bonding layer (8; 23) to bond the plurality of elements in the stack (4), wherein the fixture apparatus (1; 20) is loaded with the stack (4) and at least the clamping means (3; 25) of the fixture apparatus (1; 20) is heated at a sintering temperature.
